# EUROPÄISCHE PATENTANMELDUNG

(11) **EP 1 189 142 A2**
(43) Veröffentlichungstag der Anmeldung: **20.03.2002**
(21) Anmeldenummer: 01118364.7
(22) Anmeldetag: 27.07.2001
(51) Int. Cl.: G06F 13/40

(54) **Verfahren und Vorrichtung zum Datenaustausch zwischen Speicher- und Logikbausteinen**

(30) Priorität: 23.08.2000 DE 10041380
(71) Anmelder: Infineon Technologies AG, 81669 München (DE)
(72) Erfinder: Hottgenroth, Dirk, 80339 München (DE)
(74) Vertreter: Müller . Hoffmann & Partner Patentanwälte

(57) **Zusammenfassung**

Die Erfindung betrifft ein Verfahren und eine Vorrichtung insbesondere zum Datenaustausch zwischen Speicher- und Logikbausteinen. Ein mehrstelliges Digitalsignal auf der Senderseite wird mit einem D/A-Wandler (1) in ein entsprechendes Analogsignal umgesetzt, dieses Analogsignal (Vbus) über eine Übertragungsleitung (10) übertragen und das empfängerseitig empfangene Analogsignal mittels eines A/D-Wandlers wieder in ein mit dem Digitalsignal der Senderseite identisches Digitalsignal umgesetzt. Empfängerseitig wird ein auf dem Prinzip der sukzessiven Approximation beruhender A/D-Wandler (4) verwendet, der eine Kalibrierschaltung (5, T0, S3, S4) aufweist, die während eines Kalibrierzyklus' mittels eines zusätzlichen "Over-drive"-Transistors (T0) und eines Registers (5) Gatespannungen der zur Dekodierung dienenden Transistoren (T2, T1, T0) so lange variiert, bis das Ausgangssignal eines Vergleichers (CMP) verschwindet.

## Beschreibung

Die Erfindung betrifft ein Verfahren und eine Vorrichtung insbesondere zum Datenaustausch zwischen Speicher- und Logikbausteinen.

Die Übertragungsrate von (Speicher-)Informationen von Speicherbaustein zu Prozessor und umgekehrt ist derzeit ein Hauptfaktor für die Begrenzung der Leistungsfähigkeit der Computer. Während heutige Prozessoren Frequenzen von 800 MHz und entsprechende Übertragungsraten erreichen, liegen die Frequenzen für den Datenaustausch zwischen Prozessor/Controller und Speicher aus technischen Gründen zurzeit bei 100 bis maximal 133 MHz. Deshalb werden dringend neue Schaltungen und/oder Verfahren gesucht, um die Bedeutung dieses beschränkenden Faktors abzuschwächen und die hohen Prozessorfrequenzen auch in der Anwendung zu nutzen.

Bisherige Verfahren zur Erhöhung der Übertragungsrate beruhen im wesentlichen auf zwei Prinzipien:
(A) Erhöhung der Parallelität der Datenübertragung; das bedeutet eine höhere Pinzahl des Interfaces zwischen den Bausteinen. Die Datenübertragungsrate verhält sich linear zur Anzahl der Pins.
(B) Erhöhung der Taktfrequenz bei der Übertragung, entweder durch Erhöhung der Taktfrequenz im Prozessor und im Speicherbaustein oder durch die Nutzung der Vorder- und Rückflanke des Signals zur Übertragung jeweils einer Informationseinheit.

Ersteres führt wiederum zu einer linear mit der Frequenz steigenden Übertragungsrate, letzteres zu einer Erhöhung um den Faktor 2. Dabei ist die "reale" Frequenz auf den Datenpins bei ständig wechselnden Daten auch zweimal so groß.

Das oben unter (A) geschilderte Konzept, das z. B. in Speicher-DIMMs eingesetzt wird, ist wegen des hohen Platzbedarfs vieler Leitungen, z. B. auf einem Motherboard eines Computers und aufgrund der durch die IC-Größe begrenzten Anzahl von Interfacepins nur begrenzt umzusetzen. Zudem steigen bei vielen Leitungen die Kosten für die Motherboards und/oder die IC-Gehäuse stark an. Die gegenseitige Beeinflussung der Signale nimmt stark zu und damit die Übertragungssicherheit ab. Benutzt man mehrere Speicherbausteine parallel auf einem Modul, um die Anzahl der Pins eines einzelnen Bausteines gering zu halten, so steigt die minimale Speichergröße des Moduls stark an: z. B. liefern neun 256 MBit-Bausteine mit jeweils acht Datenleitungen eine Busbreite von 72 Bit, stellen aber einen minimalen Speicherausbau ("Granularität") von 256 Mbyte (mit Fehlerkorrektur) dar. Dies ist für viele Billiganwendungen unnötig und zu teuer.

Das oben geschilderte Konzept (B), das z. B. bei Direct-Rambus-DRAMS, Double-Data-Rate-SDRAMs genutzt wird, erlaubt eine geringere Pinzahl und damit theoretisch eine geringere Granularität. Dafür steigen jedoch die Anforderungen an die zeitliche Genauigkeit aller beteiligten Bausteine extrem an. Insbesondere ist die Datenübertragung über ein relativ langes Bussystem (einige zehn Zentimeter) mit qualitativ geringwertigen gedruckten Signalleitungen schwierig. Bei Direct Rambus mussten deshalb die Anforderungen an die Zeitgenauigkeit der Speicherbausteine extrem angehoben werden, was Produktion und Test dieser Bausteine schwierig und teuer macht und die Ausbeute verringert.

Es ist Aufgabe der Erfindung, ein Verfahren und eine Vorrichtung zum Datenaustausch insbesondere zwischen Speicher- und Logikbausteinen zu ermöglichen, mit denen die oben geschilderten Nachteile der Verfahrensweise (A) und (B) vermieden und eine Erhöhung der Datenübertragungsrate ermöglicht werden kann.

Diese Aufgabe wird anspruchsgemäß gelöst.

In allgemeiner Form benötigt man beim erfindungsgemäßen Verfahren auf der jeweiligen Senderseite einen D/A-Wandler, der mehrere Bits (digitale Zustände) für die Übertragung über eine Übertragungsstrecke (Bussystem) in einen analogen Zustand umsetzt (einen Strom oder eine Spannung). Auf der Empfängerseite muß diese Umsetzung umgekehrt werden, so dass das auf der Empfängerseite durch Analog-/Digital-Wandlung aus dem empfangenen Analogsignal erhaltene Digitalsignal identisch ist mit dem gesendeten Digitalsignal.

Für den genannten Zweck geeignete Digital-/Analog-Wandler sind bekannt. Ebenfalls gibt es einfache Analog-/Digital-Wandler, z. B. solche, die nach folgenden Prinzipien arbeiten: das Speichern eines Spannungszustandes in einem Kondensator und anschließendes Entladen des Kondensators über eine Konstantstromquelle, wobei die Dekodierung durch einen mitlaufenden Zähler erfolgt, der die für das Entladen benötigte Zeit misst, oder eine sukzessive Approximation: dabei wird auf der Empfängerseite in dem A/D-Wandler ein D/A-Wandler benutzt, dessen analoger Ausgangswert mit dem zu dekodierenden analogen Signal verglichen und solange verstellt wird, bis das entstehende Signal und das vom Sender empfangene Signal gleich groß sind. Dieses Prinzip des sukzessiv approximierenden A/D-Wandlers hat den Vorteil, dass er relativ leicht kalibrierbar ist.

Das hier vorgestellte Verfahren und die Vorrichtung kann für die obige Vorgehensweise (A) die Zahl der benötigten Pins um einen Faktor k (ganzzahlig) reduzieren, der der Anzahl der in einen Analogzustand verschlüsselten Bits des Digitalsignals entspricht. Im Fall (B) kann bei gleicher Betriebsfrequenz die Signalübertragungsrate um den Faktor k gesteigert werden oder bei konstanter Übertragungsrate die Frequenz um den Faktor k reduziert werden.

Das erfindungsgemäße Verfahren erlaubt bei einer erhöhten Bandbreite, mehrere Bausteine diesselbe Busleitung benutzen zu lassen, wie bisher bei SDRAM, EDORAMs, Direct Rambus, indem alle zu einem Zeitpunkt nicht ausgelesenen Bausteine ihre Ausgänge auf "High Impedance" schalten. Der Pegel der Busleitung wird dann alleine durch den vom aktiven Baustein getriebenen Pegel bestimmt. Das heißt, dass das System zu vorhandenen Bussystemen kompatibel ist.

Da die Dekodierung eines Analogwertes auf der Empfängerseite einige Zeit erfordert, ist es vorteilhaft, mehrere Dekoder, d. h. A/D-Wandler, pro Pin auf einem Chip, zu verwenden und die Eingangssignale zeitlich auf diese zu multiplexen. Dies würde eine weitere Erhöhung der Bandbreite ermöglichen, solange nicht die physikalischen Eigenschaften des Bussystems eine Beschränkung derselben mit sich bringen. Dazu muss das analoge Eingangssignal kurzzeitig zwischengespeichert werden, z. B. in Kondensatoren.

In einer Weiterbildung weist ein auf der Empfängerseite zu verwendender, sukzessiv approximierender Analog-/Digital-Wandler eine Kalibriervorrichtung auf, die eine einfache Kalibrierung aufgrund wenigstens eines Eingangssignals unter gleichzeitiger Vermeidung eines Diskretisierungsfehlers durchführt.

Selbstverständlich ist das erfindungsgemäße Verfahren und die zur Durchführung desselben konzipierte Vorrichtung nicht auf die Datenübertragung zwischen Speicher- und Logikbausteinen beschränkt sondern kann mit Vorteil überall dort eingesetzt werden, wo bislang bei der Übertragung digitaler Daten gewichtige Beschränkungen der Übertragungsrate zu verzeichnen waren.

Im Folgenden wird die Erfindung in Ausführungsbeispielen mit verschiedenen D/A-Wandlern und A/D-Wandlern anhand der Zeichnungen näher erläutert.
- Fig. 1: zeigt schematisch ein Ausführungsbeispiel eines 3-Bit-D/A-Wandlers zur Erzeugung eines analogen Ausgangssignals.
- Fig. 2: zeigt schematisch ein erstes Ausführungsbeispiel eines einfachen A/D-Wandlers zur Umsetzung eines analogen Eingangssignals in ein digitales Signal.
- Fig. 3: zeigt ein erstes Ausführungsbeispiel eines nach dem Prinzip der sukzessiven Approximation arbeitenden A/D-Wandlers zur Umsetzung eines Analogsignals in ein Digitalsignal mit zwei Bitstellen.
- Fig. 4: zeigt ein weiteres Ausführungsbeispiel eines nach dem Prinzip der sukzessiven Approximation arbeitenden 2-Bit-A/D-Wandlers mit einem zusätzlichen Overdrive-Transistor zur eindeutigen Dekodierung eines Analogsignals und einer zusätzlichen Kalibrierschaltung, und
- Fig. 5: zeigt ein Flussdiagramm zur Analog-/Digital-Wandlung in einen 2-Bit-Wert durch sukzessive Approximation eines A/D-Wandlers gemäß Fig. 3.

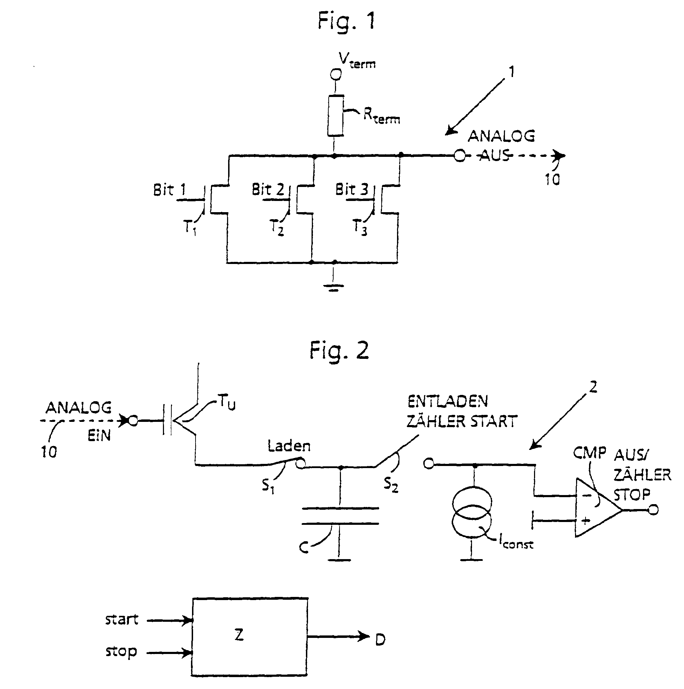

Zunächst ist in Fig. 1 eine einfache Realisierung eines einen D/A-Wandler bildenden Multilevel-Treibers gezeigt, bei dem mehrere parallel geschaltete Treiberzweige jeweils mindestens einen n-Kanal-FET T1, T2 und T3 für 3-Bit-Stellen Bit1, Bit2 und Bit3 aufweisen, die über einen Widerstand Rₜₑᵣₘ Strom aus einer Terminierungsspannung Vₜₑᵣₘ ziehen. Die Sättigungsströme dieser Zweige verhalten sich wie Zweierpotenzen. Im in der Figur dargestellten Ausführungsbeispiel verhalten sich die Treiberstromstärken Bit1 : Bit2 : Bit3 = 4 : 2 : 1. Das Ausgangssignal AUS ist ein Strom (Spannungshub), der einem n Bitstellen aufweisenden Digitalwert entspricht. Wieviele Bits tatsächlich kodiert werden können, hängt von der Messauflösung beim Dekodieren an der Empfängerseite sowie z. B. von der Größe möglicher Störsignale auf dem Bus ab, wie sie durch Übersprechen anderer Leitungen auf den auszuwertenden Pegel verursacht werden.

Der durch eine D/A-Wandler-Schaltung z. B. gemäß Fig. 1 erzeugte Analogwert wird über eine Übertragungs- oder Busleitung 10 zur Empfängerseite gesendet.

Auf der Empfängerseite befindet sich ein A/D-Wandler, der z. B. ein wie in Fig. 2 dargestellter Analog-/Digital-Wandler 2 sein kann.

Der in Fig. 2 gezeigte A/D-Wandler weist einen Kondensator C auf, der auf eine (gepufferte) Kopie des Spannungshubs von der Übertragungsleitung 10 (das Analog-Treibersignal) aufgeladen wird. Der Kondensator C hat bevorzugt eine große Kapazität mit einem entsprechend großen Ladestrom, um ein großes Signal, nämlich die gespeicherte Ladungsmenge zu erhalten. Zur Dekodierung wird der Kondensator C durch einen Schalter S1 vom Eingang getrennt und nach Schließen eines Schalters S2 von einer Konstantstromquelle I_{const} entladen. Der Digitalwert entsteht durch einen mitlaufenden, mit fester Taktfrequenz getakteten Zähler Z, der entsprechend viele Bits wie das Digitalsignal hat und der die Zeit für das Entladen des Kondensators misst. Dies bedeutet, dass der Zähler Z mit dem Schließen des Schalters S2 zu zählen beginnt und stoppt, wenn ein Vergleicher CMP ein Ausgangssignal "AUS" erzeugt. Der vom Zähler Z ableitbare Digitalwert entspricht der Ladungsmenge auf dem Kondensator C und ist bei festgelegter Kapazität desselben dem Spannungshub des analogen Eingangssignals, "ANALOG-EIN" proportional.

Es sei erwähnt, dass das Prinzip des in Fig. 2 gezeigten A/D-Wandlers bereits bekannt ist.

Um diesen in Fig. 2 gezeigten Wandler zu kalibrieren, kann man entweder einmalig nach dem Einschalten des betreffenden Bausteins oder auch periodisch den Treiber das volle Signal (alle Bits an) treiben lassen. Dann lässt sich der Messvorgang am Kondensator wiederholen und, je nachdem, ob beim Zählerstand "alle Bits an" eine vollständige Entladung des Kondensators C festgestellt wird oder nicht, der Entladestrom erniedrigen oder erhöhen, bis vollständige Entladung genau beim Zählerwert "alle Bits an" erreicht wird. Statt des Entladestroms kann hierbei auch die Taktfrequenz des Zählers variiert werden.

Alternativ kann zur Kalibrierung der Kondensator C auch nur einmal vollständig entladen werden und ein Zähler größerer Bitzahl, als eigentlich zu dekodieren sind, mitlaufen. Dieser muss bei voller Entladung mindestens den doppelten Wert, d. h. ein volles Bit mehr des gewünschten Zählerstands "alle Bit an" aufweisen und entsprechend schnell laufen. Dann kann dieser Zählerwert im Betrieb rechnerisch oder schaltungstechnisch auf den gewünschten Wert "alle Bit an" bzw. entsprechend kleinere Werte bei kleineren Eingangswerten umgesetzt werden.

Eine genauere Kalibrierung wäre dann möglich, wenn dieses Verfahren für mehrere oder sogar alle möglichen Diskretisierungswerte durchgeführt würde.

Dieser "zu schnelle" Zähler würde auch das Problem des Diskretisierungsfehlers, der besagt, dass das niedrigstwertige Bit nicht eindeutig feststellbar ist, und im Extremfall zu einem Übertrag in alle höherwertigen Bits führen kann, teilweise lösen.

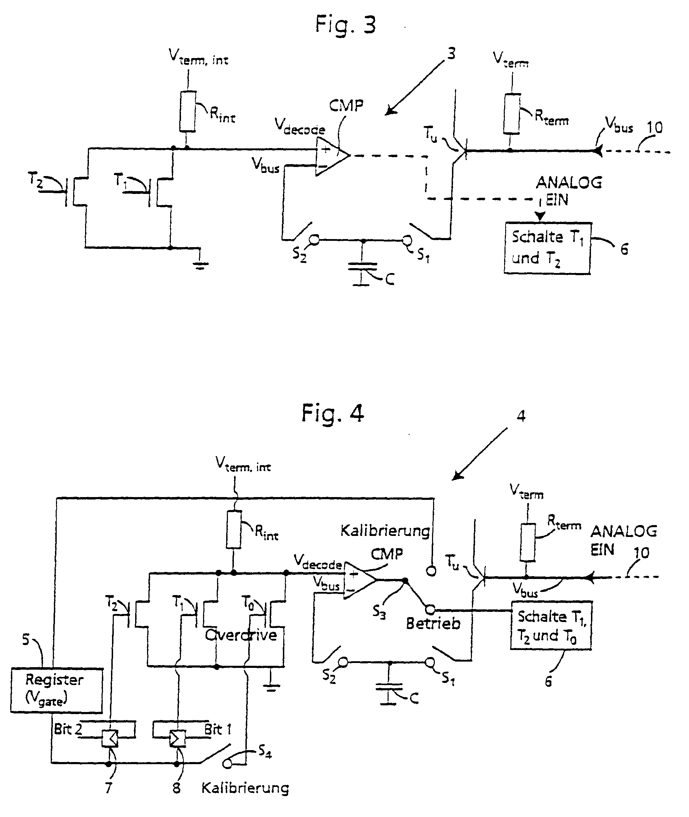

Die nachstehend anhand der Figuren 3 bis 5 beschriebenen Ausführungsbeispiele eines weiteren bei der Erfindung verwendbaren A/D-Wandlers arbeiten nach dem Prinzip der sukzessiven Approximation.

Zunächst soll anhand des Prinzipschemas in Fig. 3 das Verfahren der sukzessiven Approximation mit dem dargestellten 2-Bit-A/D-Wandler 3 beschrieben werden.

Die analoge Eingangsspannung V_{bus} vom Busleitungssystem 10 entsteht an einem Abschlußwiderstand Rₜₑᵣₘ als Spannungsabfall gegen eine Spannung Vₜₑᵣₘ. Die Spannung V_{bus} an der Busleitung 10 wird über einen Spannungsfolger Tᵤ für eine bestimmte Zeit (Größenordnung ns) durch Schließen eines Schalters S1 an einen Kondensator C angelegt, der als (kurzfristiger) Speicher für diese Spannung dient. Dann wird der Schalter S1 geöffnet, damit der Kondensator C vom Eingang der Schaltung abgekoppelt ist, und durch Schließen eines Schalters S2 wird der Kondensator C mit einem ersten Eingang eines als Vergleicher arbeitenden Differenzverstärkers CMP verbunden.

Der zweite Eingang des Differenzverstärkers CMP d.h. V_{decode} liegt über einen Widerstand Rᵢₙₜ an einer internen Spannung V_{term,int}. Um den Stromverbrauch der Schaltung gering zu halten, sollte in der Regel Rᵢₙₜ viel größer als Rₜₑᵣₘ sein.

Zur Dekodierung von zwei Bits werden zwei Transistoren T2 und T1 benutzt, deren Sättigungsströme sich wie 2 : 1 verhalten. Durch eine weiter unten anhand des Ausführungsbeispiels gemäß Fig. 4 beschriebene Kalibrierung soll sichergestellt sein, dass, wenn beide Transistoren T1, T2 eingeschaltet sind, der Spannungsabfall über Rᵢₙₜ annähernd gleich dem maximalen Spannungsabfall auf dem Bus V_{bus,max} ist. Dann kann der dekodierte Digitalwert aus dem Zustand der Gatespannungen der Transistoren abgeleitet werden. Beide Gatespannungen "hoch" entspricht "1 1", Gate von T₂ "hoch" und das von T₁ "tief" entspricht "1 0", und so weiter.

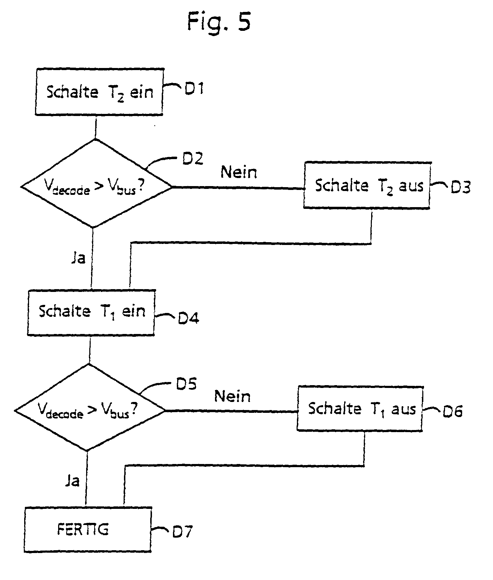

Fig. 5 zeigt anhand eines Flussdiagramms den zeitlichen Ablauf für die Dekodierung eines 2-Bit-Digitalsignals aus einem Analogsignal V_{bus} des in Fig. 3 dargestellten A/D-Wandlers, durchgeführt durch einen Steuerblock 6. In einem Schritt D1 wird der Transistor T2 eingeschaltet. Es entsteht ein Spannungsabfall über Rᵢₙₜ, am Vergleicher CMP liegt V_{decode} an. Im Schritt D2 wird abgefragt, ob V_{decode} größer als V_{bus} ist. Bejahendenfalls bleibt das höherwertige Bit 2 gesetzt und der Transistor T2 bleibt eingeschaltet. Dann wird Transistor T1 zugeschaltet. Wenn V_{decode} nicht größer als V_{bus} ist, wird im Schritt D3 Transistor T2 ausgeschaltet und Transistor T1 eingeschaltet (Schritt D4). Ist weiterhin V_{decode} größer als V_{bus} (Schritt D5), so wird der Maximalwert dekodiert und die Routine wird im Schritt D7 beendet. Der dekodierte Wert muss in diesem Fall "1 1" lauten. Wenn sich im Entscheidungsschritt D5 ergibt, dass V_{decode} nicht größer als V_{bus} ist, wird T1 ausgeschaltet. Dann ergibt sich als dekodierter Zustand im Schritt D7 entweder der Zustand "1 0" oder "0 0", abhängig von dem in Schritt D2 ermittelten Ergebnis.

Wie erwähnt, ergibt sich der dekodierte Digitalwert schließlich aus dem Zustand der Transistor-Gates (hoch = "1", tief = "0") am Ende des in Fig. 5 dargestellten zweistufigen Dekodierungsvorgangs.

Offensichtlich hat diese Schaltung ein grundsätzliches Problem, wenn man sie zur Dekodierung einer Analogspannung benutzt, die selbst durch einen 2-Bit-D/A-Wandler erzeugt wurde: wenn der Spannungshub V_{bus}, der durch das Setzen eines Bits (z. B. Bit 1) im ursprünglichen Signal entsteht, genau identisch mit demjenigen ist, der durch das Schalten von einem der Transistoren im A/D-Wandler (z. B. T1) entsteht, kann der Differenzverstärker CMP nicht entscheiden, ob das entsprechende Bit im dekodierten Signal zu setzen ist oder nicht.

In dem in Fig. 4 dargestellten Ausführungsbeispiel eines auf sukzessiver Approximation beruhenden A/D-Wandlers 4, der auf der in Fig. 3 gezeigten und eben beschriebenen Grundschaltung 3 beruht, wird deshalb vorgeschlagen, einen zusätzlichen Transistor T0 "Overdrive" einzusetzen, und zwar so, dass dessen Sättigungsstrom gerade die Hälfe desjenigen des Transtors T1 ist, d. h. die Ströme der drei Transistoren T2, T1 und T0 verhalten sich wie 4 : 2 : 1.

Wie oben erwähnt, stellt der zusätzliche "Overdrive"-Transistor T0 die Eindeutigkeit des dekodierten (2 Bit) Digitalsignals mit dem senderseitig in ein Analogsignal V_{bus} gewandelten (2 Bit) Digitalsignals her.

Ferner ist mit der in Fig. 4 gezeigten A/D-Wandlerschaltung 4 in einfacher Weise eine Kalibrierung durchführbar. Weiterhin kann eindeutig entschieden werden, ob ein Bit im ursprünglichen Digitalsignal vor der Wandlung in ein Analogsignal gesetzt war oder nicht.

Die Kalibrierung wird in einem besonderen Kalibrierzyklus durchgeführt. Dazu wird auf der Senderseite das höchstwertige Bit gesetzt und auf der Empfängerseite Schalter S3 und S4 in die Stellung "Kalibrierung" gebracht und mit dem Steuerblock 6 Transistor 2 und zusätzlich der "Overdrive"-Transistor T0 eingeschaltet. Der Ausgang des Differenzverstärkers CMP wirkt auf ein Register 5 ein, mit dem der Wert der Gatespannung V_{gate} der Transistoren T2 und T1 (über die Transfergates 7 und 8) und des "Overdrive"-Transistors T0 in feinen Stufen verstellt werden kann. Ist V_{bus,2} größer als V_{decode}, soll der Registerwert und damit V_{gate} erhöht werden. Ist V_{bus,2} kleiner als V_{decode}, soll der Registerwert und damit V_{gate} erniedrigt werden. Das Einschalten der Transistoren T1 und T2 erfolgt also nicht mit vollem Hochpegel auf dem Gate, sondern durch eine durch die Spannung V_{gate} des Registers 5 justierbare Gatespannung. Das Ein-/Aussignal wird lediglich auf ein Transfergate 7, 8 geschaltet, welches die Transistorgates mit der justierbaren Spannung V_{gate} verbindet.

Die Spannung V_{gate} des Registers 5 wird solange verstellt, bis eine gewisse Schwelle für den Betrag der Ausgangsspannung des Differenzverstärkers CMP unterschritten wird, d. h. V_{bus} und V_{decode} nahezu gleich sind. Für eine sichere Bewertung kann auch die über eine gewisse Zeit integrierte Ausgangsspannung des Verstärkers CMP genutzt werden. Dies macht allerdings den Kalibriervorgang zeitaufwendiger.

Bei diesem Kalibrierverfahren ist durch den "overdrive-Transistor T₀" sichergestellt, dass auf der Empfängerseite, d. h. auf der Seite des A/D-Wandlers 4 etwas mehr Strom gezogen werden muss als durch T2 alleine, damit der Differenzverstärker CMP ein verschwindendes Ausgangssignal hat, nämlich den Strombeitrag, den der "Overdrive"-Transistor T0 liefert. Lässt man im normalen Dekodierbetrieb den "Overdrive"-Transistor T0 stets ausgeschaltet, so wird immer, wenn im ursprünglichen Signal vor der D/A-Wandlung im Sender ein Bit gesetzt war, dieses auch im beschriebenen und in Fig. 4 gezeigten A/D-Wandler 4 gesetzt, was aus der obigen Beschreibung der Dekodierung hervorgeht.

Das beschriebene Prinzip ist selbstverständlich auf k Bits erweiterbar, wobei die Tranistoren Tk, T(k-1), ..., T1, T0 Sättigungsströme im Verhältnis 2^{(k+1)} : 2^{k}: ...: 2: 1 haben müssen. Dies lässt sich bei der Herstellung einer Schaltung leicht durch Parallelschaltung entsprechend vieler identischer Transistoren erreichen.

Die Kalibrierung kann verfeinert/überprüft werden, wenn man im ursprünglichen Signal nicht nur das höchstwertige Bit setzt, sondern den Vorgang für verschiedene Bits oder auch Bitkombinationen wiederholt. Dies verlängert jedoch den Kalibrierzyklus.

Durch die Kalibrierung auf der Empfängerseite werden Einflüsse einer möglichen Dämpfung zwischen Senderseite und Empfängerseite ausgeschaltet. Dies beruht darauf, daß eine korrekte Dekodierung empfängerseitig auch dann durchgeführt wird, wenn das von der Senderseite übertragene Analogsignal auf der Empfängerseite als Eingangssignal nur abgeschwächt ankommt. Die Kalibrierung nutzt nämlich nur die Linearität des Eingangssignals auf der Empfängerseite zum gesendeten Signal und nicht eine Identität von Absolutwerten des von der Senderseite abgegebenen Sendesignals mit dem am Empfänger ankommenden Signal.

## Patentansprüche

1. Verfahren zum Datenaustausch, insbesondere zwischen Speicher- und Logikbausteinen,
**dadurch gekennzeichnet,**
- **dass** auf der Senderseite ein mehrstelliges Digitalsignal in ein entsprechendes Analogsignal umgesetzt,
- **dass** dieses Analogsignal übertragen und
- **dass** auf der Empfängerseite das übertragene Analogsignal wieder in ein mit dem mehrstelligen Digitalsignal der Senderseite identisches mehrstelliges Digitalsignal umgesetzt wird.

2. Verfahren nach Anspruch 1,
**dadurch gekennzeichnet,**
**dass** auf der Empfängerseite mehrere empfangene Analogsignale gespeichert und im Zeitmultiplex verarbeitet werden.

3. Verfahren nach Anspruch 1 oder 2,
**dadurch gekennzeichnet,**
**dass** auf der Empfängerseite eine Kalibrierung des aus dem empfangenen Analogsignal umgesetzten Digitalsignals, bezogen auf wenigstens einen Signalwert, durchgeführt wird.

4. Verfahren nach Anspruch 3,
**dadurch gekennzeichnet,**
**dass** der zu kalibrierende Signalwert der maximale Signalwert ist.

5. Verfahren nach Anspruch 3 oder 4,
**dadurch gekennzeichnet,**
**dass** durch die Kalibrierung auf der Empfängerseite Einflüsse einer Dämpfung zwischen Senderseite und Empfängerseite ausgeschaltet werden.

6. Verfahren nach einem der Ansprüche 3 bis 5,
**dadurch gekennzeichnet,**
**dass** die Kalibrierung auf der Empfängerseite die Linearität des in die Empfängerseite eingespeisten Analogsignals nutzt.

7. Vorrichtung zum Datenaustausch, insbesondere zwischen Speicher- und Logikbausteinen zur Durchführung des Verfahrens nach einem der Ansprüche 1 bis 6,
**dadurch gekennzeichnet,**
- **dass** auf der Senderseite ein Digital-/Analog(D/A)-Wandler (1) vorgesehen ist, der mehrere Bitstellen eines Digitalsignals in ein entsprechendes Analogsignal umwandelt,
- **dass** eine Übertragungsstrecke (10) zur Übertragung des Analogsignals eingerichtet ist, und
- **dass** auf der Empfängerseite ein Analog-/Digital(A/D)-Wandler (2; 3; 4) vorgesehen ist, der das übertragene und empfangene Analogsignal wieder in ein mit dem mehrstelligen Digitalsignal auf der Senderseite identisches mehrstelliges Digitalsignal zurückwandelt.

8. Vorrichtung nach Anspruch 7,
**dadurch gekennzeichnet,**
**dass** ein A/D-Wandler (2) eingesetzt ist, der den jeweiligen Spannungszustand des empfangenen Analogsignals kurzzeitig in einen Kondensator (C) speichert, der anschließend über eine Konstantstromquelle (I_{const}) entladen wird, und
die Dekodierung durch einen mitlaufenden Zähler (Z) so durchgeführt wird, dass dieser die für die Entladung des Kondensators (C) benötigte Zeit misst.

9. Vorrichtung nach Anspruch 7,
**dadurch gekennzeichnet,**
**dass** ein A/D-Wandler (3; 4) eingesetzt ist, der nach dem Prinzip der sukzessiven Approximation arbeitet und einen internen D/A-Wandler (T1, T2, T0) aufweist, dessen analoger Ausgangswert (V_{decode}) durch einen Vergleicher (CMP) mit dem empfangenen zu dekodierenden analogen Signal (V_{bus}) verglichen und solange verstellt wird, bis das entstehende Analogsignal (V_{decode}) und das vom Sender gesendete Analogsignal (V_{bus}) gleich groß sind.

10. Vorrichtung nach Anspruch 9,
**dadurch gekennzeichnet,**
**dass** der interne D/A-Wandler des A/D-Wandlers (4) eine Kalibriervorrichtung (5, T0, S3, S4) aufweist, die eine Kalibrierung des zum Vergleich erzeugten Digitalsignals für wenigstens einen Wert des analogen Eingangssignals (V_{bus}) durchführt.

11. Vorrichtung nach Anspruch 10,
**dadurch gekennzeichnet,**
**dass** die Kalibriervorrichtung in dem D/A-Wandler des sukzessiv approximierenden A/D-Wandlers (4) einen zusätzlichen "Overdrive"-Transistor (T0), dessen Sättigungsstrom genau die Hälfte des Sättigungsstroms des der niedrigstwertigen Bitstelle des umgesetzten Digitalsignals entsprechenden Transistors (T1) ist und Mittel (5, S3, S4, 7, 8) aufweist, mit denen in Abhängigkeit von der Größe eines von der Senderseite gesendeten Kalibriersignals die durch die Transistoren (T₀, T₁, T₂) des D/A-Wandlers des sukzessiv approximierenden A/D-Wandlers (4) fließenden Ströme in feinen Stufen solange verstellt werden, bis das als Kalibriersignal empfangene Analogsignal (V_{bus}) und das vom D/A-Wandler des sukzessiv approximierenden A/D-Wandlers (4) erzeugte Vergleichskalibriersignal nahezu identisch sind.

12. Analog-/Digital-Wandler nach dem Prinzip der sukzessiven Approximation mit einer Kalibriervorrichtung nach einem der Ansprüche 10 oder 11.
